# EUROPEAN PATENT SPECIFICATION

(11) **EP 0 590 232 B1**
(45) Date of publication and mention of the grant of the patent: **06.08.1997**
(21) Application number: 93104783.1
(22) Date of filing: 23.03.1993
(51) Int. Cl.: H01S 3/043, H01S 3/25, H01L 33/00

(54) **Semiconductor laser array**
Vielfachhalbleiterlaser
Dispositif laser multiple à semi-conducteur

(30) Priority: 28.09.1992 JP 284064/92
(43) Date of publication of application: 06.04.1994
(73) Proprietor: MITSUBISHI DENKI KABUSHIKI KAISHA, Tokyo 100 (JP)
(72) Inventor: Shigihara, Kimio, c/o Mitsubishi Denki K. K., Itami-shi, Hogo 664 (JP); Watanabe, Hitoshi, c/o Mitsubishi Denki K. K., Itami-shi, Hogo 664 (JP); Kadowaki, Tomoko, c/o Mitsubishi Denki K. K., Itami-shi, Hogo 664 (JP); Nishiguchi, Harumi, c/o Mitsubishi Denki K. K., Itami-shi, Hogo 664 (JP); Isshiki, Kunihiko, c/o Mitsubishi Denki K. K., Itami-shi, Hogo 664 (JP)
(74) Representative: Prüfer, Lutz H., Dipl.-Phys.

(56) References cited:
- EP-A- 0 350 327
- EP-A- 0 390 313
- US-A- 4 069 463
- PATENT ABSTRACTS OF JAPAN vol. 10, no. 11 (E-374)17 January 1986 & JP-A-60 175 476
- PATENT ABSTRACTS OF JAPAN vol. 7, no. 204 (E-197)(1349) 9 September 1983 & JP-A-58 102 590
- PATENT ABSTRACTS OF JAPAN vol. 9, no. 47 (E-299)27 February 1985 & JP-A-59 188 152
- JOURNAL OF APPLIED PHYSICS vol. 70, no. 9 , 1 November 1991 , NEW YORK, US pages 4715 - 4723 XP274140 S. MURATA, K. NISHIMURA 'A Simple New Laser Diode Array Model for Thermal Interaction Analysis'

## Description

### FIELD OF THE INVENTION

The present invention relates to a semiconductor laser device including a laser array chip in which a plurality of stripe-shaped active regions are driven independently and a heat sink on which the laser array chip is disposed and, more particularly to heat sinks that improve performance of the laser array chip. The invention also relates to a method for producing the semiconductor laser device.

### BACKGROUND OF THE INVENTION

When a semiconductor laser chip is mounted on a chip-mounting part of a package, such as a metal block, a heat sink is inserted between the metal block and the laser chip to reduce thermal stress applied to the laser chip due to a difference in thermal expansion coefficients between the metal block and the laser chip.

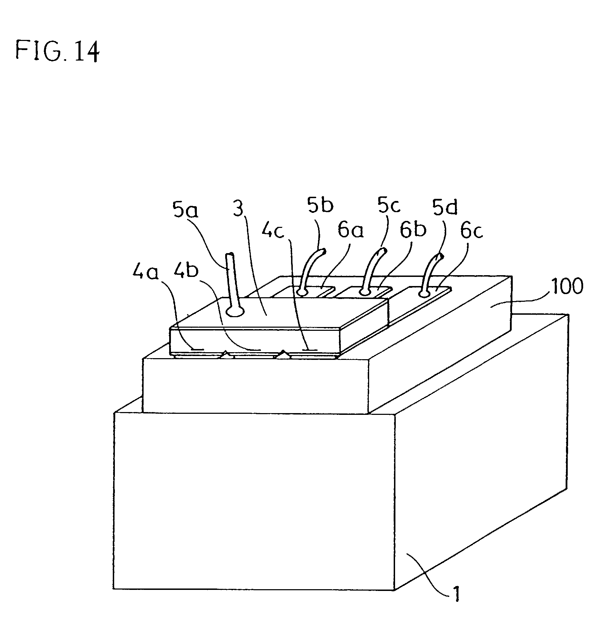

Figure 14 is a perspective view illustrating a semiconductor laser chip mounted on a metal block via a conventional heat sink. In figure 14, reference numeral 1 designates a metal block comprising silver, copper, or the like. A heat sink 100 comprising a material of high thermal conductivity, for example, silicon or diamond, is disposed on the metal block 1. A semiconductor laser array chip 3 including three active regions 4a, 4b, and 4c, each active region producing light of a different wavelength, is disposed on the heat sink 100. Electrode patterns 6a, 6b, and 6c, which respectively correspond to the active regions 4a, 4b, and 4c of the laser chip 3, are disposed on the heat sink 100. Metal wires 5b, 5c, and 5d are connected to the electrode patterns 6a, 6b, and 6c, respectively. A metal wire 5a is connected to a common electrode of the semiconductor laser chip 3.

A description is given of the operation. Current is injected into the active regions 4a, 4b, and 4c separately from each other through the electrode patterns 6a, 6b, and 6c, respectively, which electrode patterns are separated from each other on the insulating heat sink 100, whereby the respective active regions are independently operated. Heat generated in each active region due to the laser light emission is transmitted through the heat sink 100 and the metal block 1. Since the heat sink 100 comprises a material having thermal isotropy, the heat generated in the active region is transmitted in the heat sink 100 extending not only in the vertical direction, i.e., the direction toward the metal block, but also in the horizontal direction. Therefore, in the laser array device with the conventional heat sink 100, heat generated in an active region (first active region) is unfavorably transmitted to another active region (second active region) through the heat sink 100 increasing the temperature of the second active region, whereby laser characteristics of the second active region, such as oscillation wavelength, operating current, and the like, are adversely affected by the heat from the first active region, that is, a thermal crosstalk occurs.

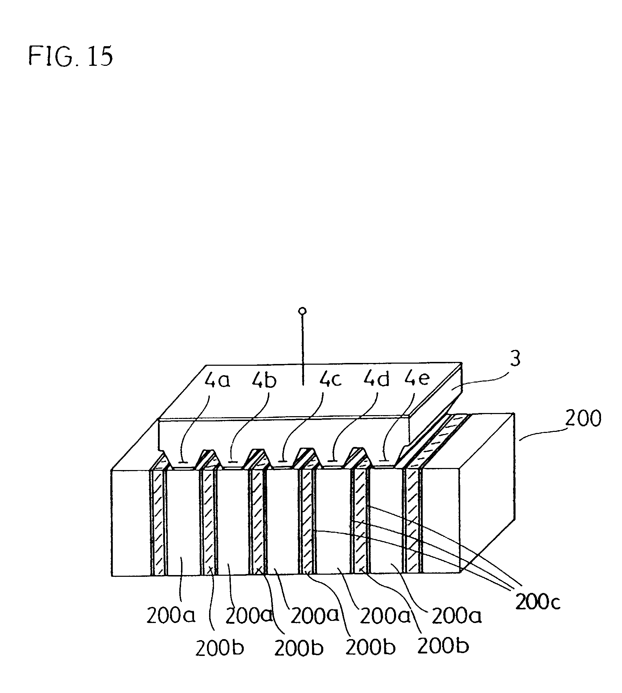

Figure 15 is a perspective view illustrating a semiconductor laser device including a heat sink that prevents thermal crosstalks between a plurality of active regions of a laser array, which is disclosed in Japanese Published Patent Application No. 60-175476. In figure 15, the heat sink 200 comprises a plurality of conductive heat sink layers 200a comprising copper (Cu) having a thermal conductivity of 3.9 W/cm°C and a plurality of insulating layers 200b comprising alumina (Al₂O₃) having a thermal conductivity of 0.21 W/cm°C, which are alternately laminated and adhered to each other using hard solder 200c. Preferably, the hard solder 200c is silver solder (AgₓCu₁₋ₓ) or gold solder (AuₓCu₁₋ₓ). The semiconductor laser array chip including five active regions 4a, 4b, 4c, 4d, and 4e is disposed on the heat sink 200 so that an electrode of each active region is in contact with each heat sink layer 200a of the heat sink 200.

A description is given of the operation. Since the active regions 4a to 4e of the laser array chip 3 are in contact with the conductive heat sink layers 200a and electrically separated from each other by the insulating layers 200b, the respective active regions are independently driven by voltages applied via the corresponding conductive heat sink layers 200a. Heat generated in each active region due to the laser light emission is transmitted through the heat sink 200. If a low thermal conductivity material is used for the insulating layer 200b, the heat transmitted to the conductive heat sink layer 200a does not easily extend into the insulating layer 200b, thereby preventing a temperature rise in an active region due to heat generated in adjacent active region, i.e., the thermal crosstalk is reduced.

When the semiconductor array chip with the conventional heat sink comprising alternating conductive layers and insulating layers is mounted on a metal block of a package to complete a semiconductor laser device, an insulator should be inserted between the metal block and the heat sink or the laser chip should be mounted on an insulator block instead of the metal block to prevent a short circuit between adjacent active regions of the laser array chip, resulting in a complicated fabrication. Furthermore, the fabrication of the conventional heat sink including adhering the high thermal conductivity material and the low thermal conductivity material using the hard solder takes much time and labor, and it is difficult to fabricate the heat sink with high dimensional precision. From US-A-4 069 463 a semiconductor laser array chip is known, including a plurality of stripe-shaped active regions, where each stripe-shaped active region is being driven independently. The laser chip is disposed on a heat sink, wherein the heat sink comprises grooves that are filled with electrically conductive material which serves as the second electrode of the individual lasers. As the substrate is a silicon substrate, care has to be taken to avoid short-circuting of the individual grooves.

### SUMMARY OF THE INVENTION

It is an object of the present invention to provide a semiconductor laser device that prevents thermal crosstalks between active regions of the laser array.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

The objects of the present invention are met by a semiconductor laser device according to one of claims 1 or 3 to 5. Further development of the invention can be obtained from the Subclaims.

### BRIEF DESCRIPTION OF THE DRAWINGS

Figure 1 is a perspective view illustrating an example of a semiconductor laser device which is useful for the understanding of the present invention;
Figures 2(a)-2(d) are perspective views illustrating a method for producing a heat sink included in the semiconductor laser device of figure 1;
Figure 3 is a perspective view illustrating a semiconductor laser device in accordance with a second example useful for understanding the present invention;
Figure 4 is a perspective view illustrating a semiconductor laser device in accordance with a first embodiment of the present invention;
Figure 5 is a perspective view illustrating a semiconductor laser device in accordance with a second embodiment of the present invention;
Figure 6 is an enlarged view of a portion of the semiconductor laser device of figure 4;
Figures 7(a)-7(c) are diagrams illustrating a method for producing a heat sink included in the semiconductor laser device of figure 4;
Figure 8 is a perspective view illustrating a semiconductor laser device in accordance with a third embodiment of the present invention;
Figure 9 is a perspective view illustrating a semiconductor laser device in accordance with a fourth embodiment of the present invention;
Figure 10 is a perspective view illustrating a semiconductor laser device in accordance with a fifth embodiment of the present invention;
Figures 11(a)-11(b) are diagrams illustrating a heat sink included in the semiconductor laser device of figure 12;
Figure 12 is a perspective view illustrating a semiconductor laser device in accordance with a sixth embodiment of the present invention;
Figures 13(a)-13(b) are diagrams illustrating a heat sink included in the semiconductor laser device of figure 12;
Figure 14 is a perspective view illustrating a semiconductor laser device including a heat sink according to the prior art; and
Figure 15 is a perspective view illustrating a semiconductor laser device including a heat sink according to the prior art.

### DETAILED DESCRIPTION OF THE PREFERRED EMBODIMENTS

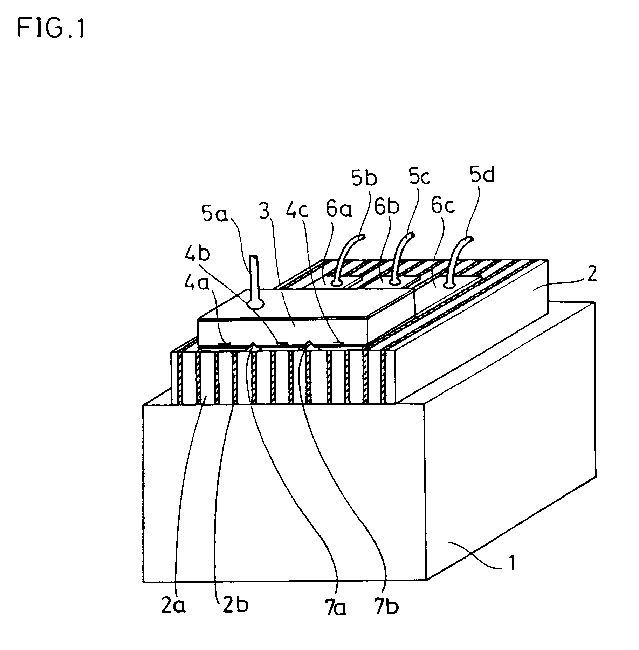

Figure 1 is a perspective view illustrating a semiconductor laser device in accordance with a first example useful for the understanding of the present invention. In figure 1, reference numeral 1 designates a metal block comprising silver, copper, or the like. A heat sink 2 is disposed on the metal block 1. The heat sink 2 comprises a plurality of heat-radiating layers 2a comprising a first insulating material and having a relatively high thermal conductivity and a plurality of heat-insulating layers 2b comprising a second insulating material and having a relatively low thermal conductivity, which layers 2a and 2b are alternately laminated. Preferably, the first insulating material is diamond having a thermal conductivity of 20W/cm°C the second insulating material is SiO₂ having a thermal conductivity of 0.014W/cm°C. A semiconductor laser array chip 3 including three active regions 4a, 4b, and 4c is disposed on the heat sink 2. Electrode patterns 6a, 6b, and 6c corresponding to the active regions 4a, 4b, 4c, respectively, are disposed on the heat sink 2. Metal wires 5b, 5c, and 5d are connected to the electrode patterns 6a, 6b, and 6c, respectively, and a metal wire 5a is connected to a common electrode of the semiconductor laser chip 3. The active regions 4a, 4b, and 4c are electrically isolated from each other by stripe grooves 7a and 7b.

A description is given of the operation. The heat sink 2 employed in the semiconductor laser device of figure 1 comprises the heat-radiating layers (diamond layers) 2a and the heat-insulating layer (SiO₂ layers) 2b which are alternately laminated in the array direction of the active regions. Therefore, heat generated in each of the active regions 4a, 4b, and 4c is transmitted to the metal block 1 through the heat-radiating layer 2a. On the other hand, the heat conductivity of the heat sink 2 in the horizontal direction is poor because of the periodic presence of the heat-insulating layers 2b, so that the heat does not extend in the horizontal direction. As a result, heat transmission between adjacent active regions through the heat sink is reduced, providing a semiconductor laser array with less thermal crosstalk.

According to the first example, since the high thermal conductivity layers 2a and the low thermal conductivity layers 2b, which are alternately laminated in the array direction of the active regions of the laser chip 3 to constitute the heat sink 2, comprise insulating materials, crosstalks between the active regions are reduced. In addition, when the laser array chip with the heat sink is disposed on a metal block, no short circuit occurs between adjacent active regions of the laser array. In addition, fabrication process of the semiconductor laser device is simplified.

Among insulating materials, diamond, which is employed in the first embodiment of the present invention, has a much higher thermal conductivity than copper (thermal conductivity: 3.9W/cm°C) and silver (thermal conductivity: 4.28W/cm°C) which are conductive materials having relatively high thermal conductivities. When such a high thermal conductivity insulating material is used as the heat-radiating layer 2a, a heat sink with improved heat-radiating efficiency is achieved.

While in the above-described first example diamond and SiO₂ are used as materials of the heat-radiating layer 2a and the heat-insulating layer 2b, respectively, the materials are not restricted thereto. For example, CBN (Cubic Boron Nitride) having a thermal conductivity of 6W/cm °C) may be used as the material of the heat-radiating layer.

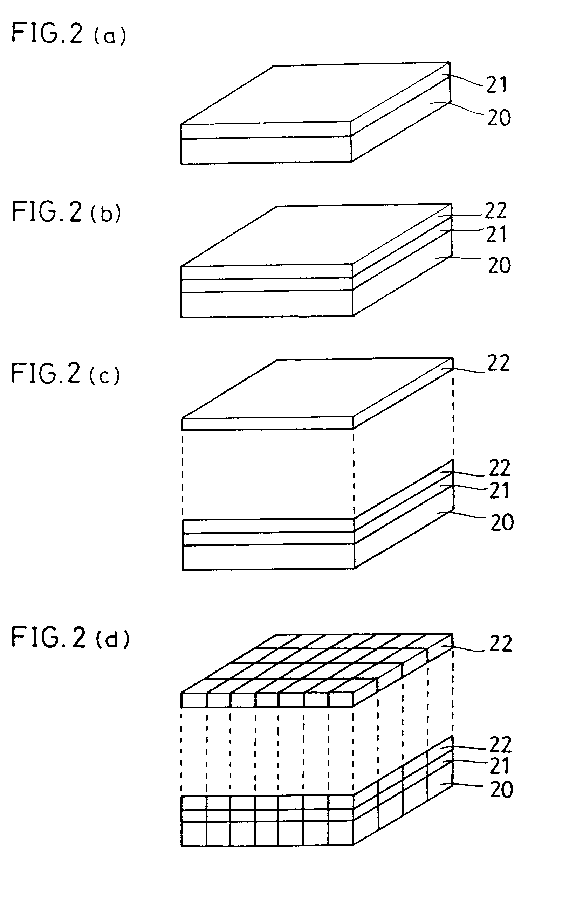

Figures 2(a)-2(d) are perspective views illustrating a method for producing the heat sink of the semiconductor laser device of figure 1. In the figures, reference numeral 20 designates an SiO₂ substrate, numeral 21 designates diamond layers, and numeral 22 designates SiO₂ layers.

Initially, as illustrated in figure 2(a), diamond, which is an insulating material having a relatively high thermal conductivity, is deposited on an SiO₂ substrate 20 to a prescribed thickness by CVD. Then, as illustrated in figure 2(b), SiO₂, which is an insulating material having a relatively low thermal conductivity, is deposited on the diamond layer 21 to a prescribed thickness by sputtering. The alternating growths of the diamond layer 21 and the SiO₂ layer 22 are repeated to form a laminated structure of a prescribed thickness as shown in figure 2(c). Thereafter, as illustrated in figure 2(d), the laminated structure is divided into a plurality of blocks, each block having desired size and shape, using a dicing saw or a laser saw. Then, electrode patterns are produced on the surface of each block to complete a heat sink for a semiconductor laser device.

In this method, a plurality of heat sinks having uniform characteristics are easily produced from a large-sized block, improving the production yield.

During producing the laminated structure by CVD or sputtering, thicknesses of the respective layers are easily controlled, so that the dimensional precision is significantly improved as compared with the conventional method of adhering thin films using hard solder.

While in the above-described method the diamond layer 21 is grown by CVD and the SiO₂ layer 22 is grown by sputtering, both layers may be successively grown by CVD in a CVD apparatus. In addition, the growth methods of the respective materials are not restricted to CVD and sputtering. For example, vacuum deposition may be employed.

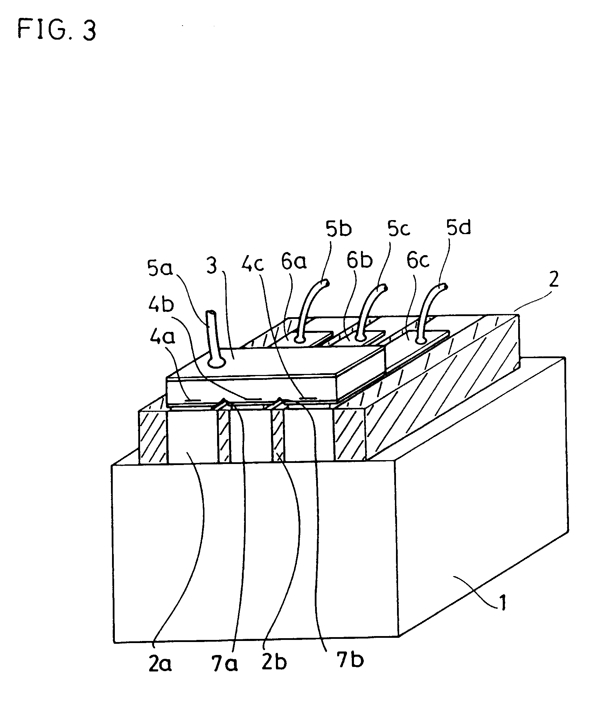

Figure 3 is a perspective view illustrating a semiconductor laser device including an improved heat sink in accordance with a second example useful for the understanding of the present invention. In figure 3, the same reference numerals as in figure 1 designate the same or corresponding parts.

In the semiconductor laser device shown in figure 1 according to the first example, the heat-insulating layers 2b are present beneath the active regions 4a to 4c of the semiconductor laser array chip 3 while the heat-radiating layers 2a are present beneath the grooves for isolation 7a and 7b.

In order to improve the performance of the heat sink of the first example, an increase in the heat-radiating efficiency of the heat sink and a decrease in crosstalks between adjacent active regions of the laser array should be achieved. To increase the heat-radiating efficiency of the heat sink, portions of the heat sink beneath the respective active regions of the laser array should be formed of the high thermal conductivity material. To decrease crosstalks between the active regions of the laser array, the low thermal conductivity layers of the heat sink disposed beneath regions between adjacent active regions should be thick.

The heat sink according to this second example shown in figure 3 satisfies the above-described conditions. More specifically, in figure 3, each of the active regions 4a, 4b, and 4c of the laser array is disposed on the insulating layer 2a having a relatively high thermal conductivity and the same width as the active region, and each of the grooves for isolation 7a and 7b is disposed on the insulating layer 2b having a relatively low thermal conductivity and the same width as the groove. In this structure, the heat-radiating efficiency is further improved and the crosstalks between the active regions are further reduced as compared with the semiconductor laser device of figure 1.

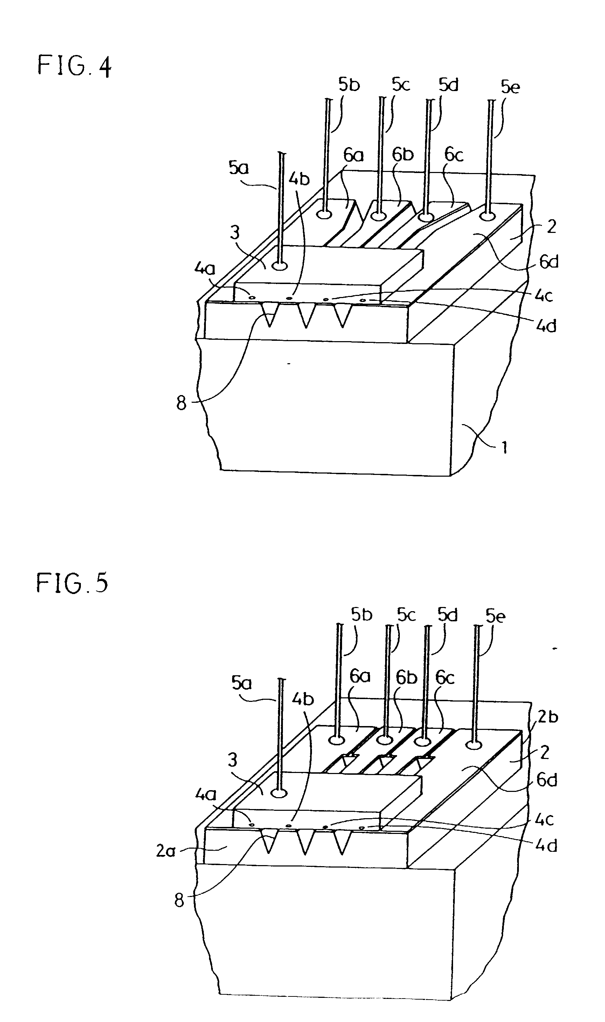

Figure 4 is a perspective view illustrating a semiconductor laser device in accordance with a first embodiment of the present invention. In figure 4, reference numeral 1 designates a metal block. A heat sink 2 comprising an insulating material, such as silicon, and having three stripe V grooves 8 is disposed on the metal block 1. A laser array chip 3 including a plurality of active regions 4a to 4d, each active region producing light of a different wavelength, is disposed on the heat sink 2. Electrode patterns 6a to 6d corresponding to the active regions 4a to 4d, respectively, are disposed on the heat sink 2. Metal wires 5b to 5e are connected to the electrode patterns 6a to 6d, respectively, and a metal wire 5a is connected to a common electrode of the semiconductor laser chip 3.

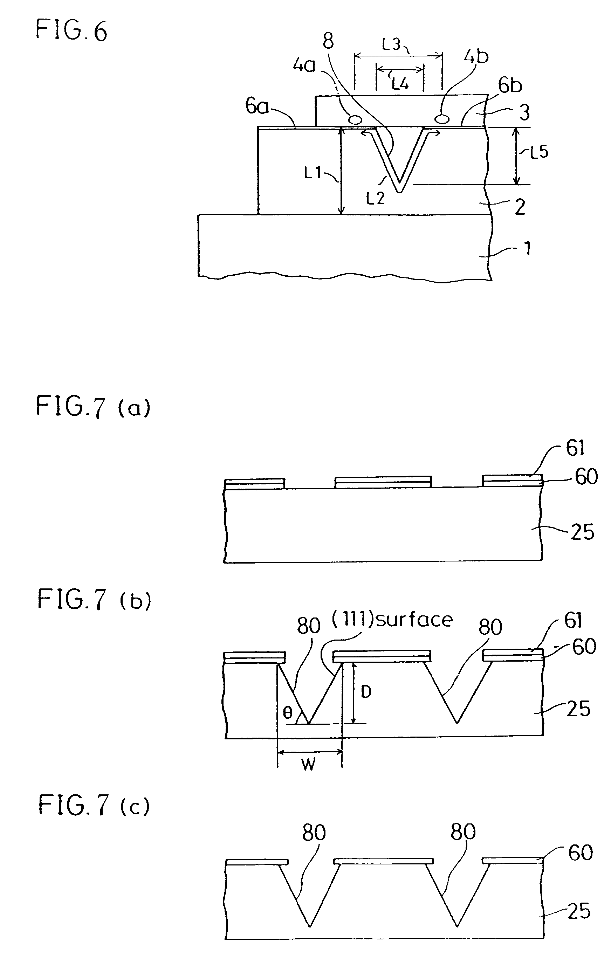

A description is given of the operation. Figure 6 is an enlarged view of a portion of the structure shown in figure 4. In figure 6, the same reference numerals as in figure 4 designate the same or corresponding parts. In this third embodiment, the V groove 8 is present beneath a region of the laser chip 3 between adjacent active regions 4a and 4b, so that air is present beneath that region. Since thermal conductivity of air is lower than thermal conductivity of silicon constituting the heat sink, heat, which is generated in the active region 4a and transmitted in the heat sink toward the active region 4b, flows around the air region, along the side walls of the V groove 8. Accordingly, if the thickness of the heat sink 2, i.e., the distance L1 from the surface of the heat sink to the surface of the metal plate 1 is shorter than the distance L2 between the adjacent active regions 4a and 4b along the V groove 8, the transmission of heat from the active region 4a to the active region 4b through the heat sink 2 is effectively suppressed, reducing the thermal crosstalk between the active regions 4a and 4b.

In the above-described first embodiment, the region contributing to the heat radiation of the heat sink is trapezoid in cross section in which the width increases with the distance from the active region. In this case, heat radiation from the laser chip is improved as compared with the rectangular heat-radiating region because heat from the active region flows radiately in that region.

Figures 7(a)-7(c) illustrates a method for producing the heat sink 2 of figure 4.

Initially, a (100) surface of an insulating silicon substrate 25 is metallized to form a metal layer 60 and a photoresist 61 is deposited on the metal layer 60. Then, the metal layer 60 and the photoresist 61 are patterned as shown in figure 7(a) using conventional photolithography and etching. Using this pattern as a mask, the silicon substrate 25 is etched by an etchant comprising KOH, water, and isopropyl alcohol, to form V grooves 80 in which (111) surfaces are exposed as shown in figure 7(b). Since the gradient of the (111) surface to the (100) surface is about 54.7 , if the width W of the groove 80 is 100 microns, the depth D of the groove is about 71 microns. After the etching, the photoresist 61 is removed as shown in figure 7(c), followed by dicing to cut the substrate 25 in a desired size, completing the heat sink 2. The metal layers 60 serve as the electrode patterns 6a to 6d.

In figure 6, when the interval L3 between adjacent active regions 4a and 4b of the semiconductor laser array chip 3 is 200 microns, a silicon substrate 150 microns thick is used for the heat sink, and the V grooves 80 each having an aperture width L4 of 100 microns are formed in the substrate according to the method of figures 7(a)-7(c), the depth L5 of each groove 80 becomes about 71 microns as described above, whereby the distance L2 between the active regions 4a and 4b along the V groove 8 is sufficiently longer than the distance L1 from the active region to the surface of the metal layer 1.

While in the above-described first embodiment the heat sink substrate comprises insulating silicon, it may comprise other insulating materials.

Figure 5 is a perspective view illustrating a semiconductor laser device in accordance with a second embodiment of the present invention. In figure 5, the V grooves 8 do not reach the rear surface 2b of the heat sink 2, and only the electrode patterns 6a to 6d are separated from each other, whereby mechanical strength of the heat sink is increased as compared with the first embodiment of the present invention.

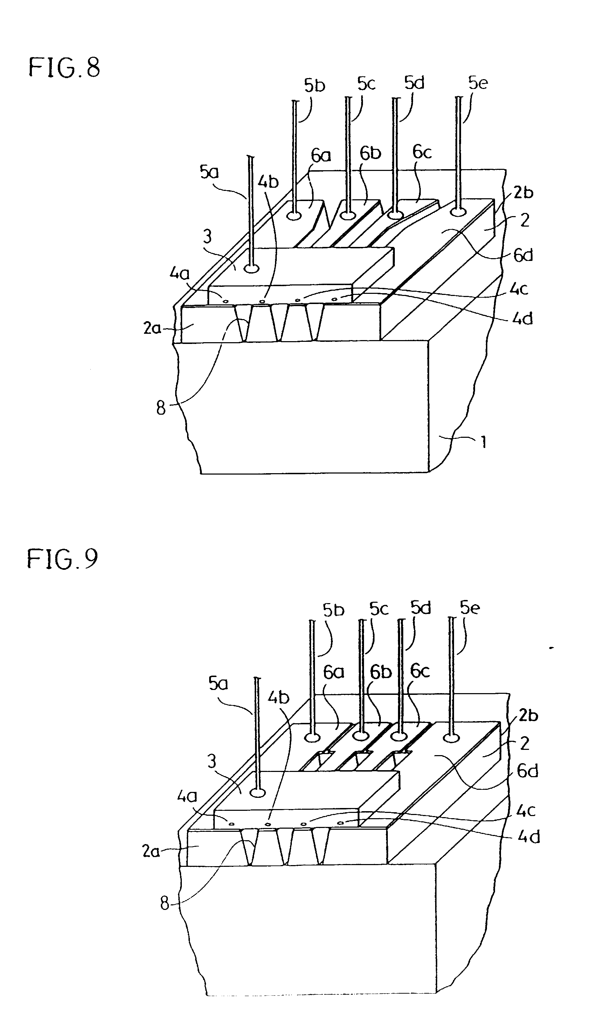

Figure 8 is a perspective view illustrating a semiconductor laser device in accordance with a third embodiment of the present invention. In figure 8, the grooves 8 penetrate through the heat sink substrate, so that the trapezoid heat-radiating regions of the heat sink are separated from each other. Also in this embodiment, the same effects as described in the first embodiment is be attained.

In the above-described third embodiment, since the V grooves 8 are formed from the front surface 2a to the rear surface 2b of the heat sink 2, so that the heat sink 2 is completely divided into four blocks, resulting in a complicated fabrication process. Figure 9 is a perspective view illustrating a semiconductor laser device in accordance with an fourth embodiment of the present invention. In this fourth embodiment, the V grooves 8 do not reach the rear surface 2b of the heat sink and only the electrode patterns 6a to 6d are separated from each other, so that the heat sink 2 is formed as one block in a relatively simple process.

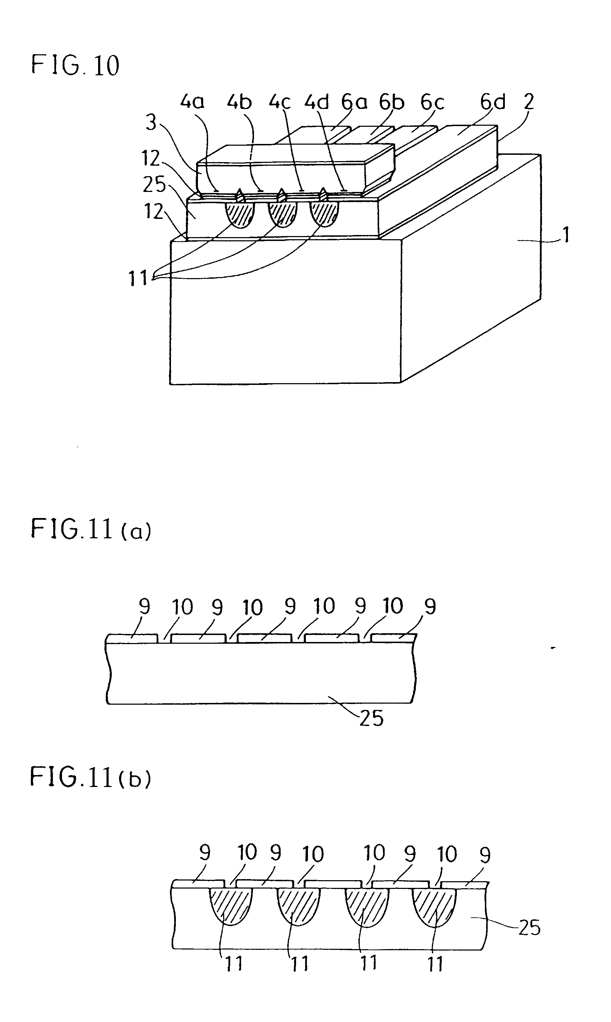

Figure 10 is a perspective view illustrating a semiconductor laser device in accordance with a fifth embodiment of the present invention. In figure 10, the heat sink 2 includes three impurity diffused regions 11 which are formed by a selective diffusion of impurity into a heat sink substrate 25 comprising insulating silicon.

A description is given of the operation. A reduction in thermal crosstalks between active regions of the semiconductor laser array according to this fifth embodiment is based on the same principle as described in the first embodiment. That is, in this fifth embodiment, a region between adjacent active regions of the laser array is disposed on each impurity diffused region 11 formed in the heat sink 2. It is well known that the impurity diffused region produced in the silicon substrate has lower thermal conductivity than the other region of the substrate in which no impurity is diffused. Therefore, in figure 10, heat, which is generated in the active region 4a and transmitted toward the active region 4b, flows around the impurity diffusion region 11, along the diffusion front. Accordingly, if the distance from the active region 4a to the surface of the metal block 1 is shorter than the distance between the active regions 4a and 4b along the diffusion front of the impurity diffused region 11, the heat transmission from the active region 4a to the active region 4b through the heat sink 2 is effectively suppressed, reducing the thermal crosstalk between those regions.

Figures 11(a) and 11(b) illustrate a method for producing the heat sink 2 of figure 10.

Initially, a metal film comprising Au or the like, an insulating film, or a conductive film is deposited over the surface of the heat sink substrate 25 comprising insulating silicon. Then, the film is selectively etched leaving portions, each portion having the same width as each element of the laser array 3, resulting in a mask for selective diffusion 9 with apertures 10 (figure 11(a)).

Then, an impurity, for example, phosphorus or boron, is diffused into the silicon substrate 25 using the mask 9 having the apertures 10, producing impurity diffused regions 11 at equal spaces to a prescribed depth 11 (figure 11(b)).

Thereafter, metal or solder 12 is deposited on both surfaces of the heat sink substrate 25, whereby the heat sink is easily soldered to the laser array chip 3, a mount, or a package. When the diffusion mask 9 comprises metal, the metal or solder film 12 is dispensed with, simplifying the production process. The metal or solder film 12 may be deposited after removing the diffusion mask 9.

In fabricating the semiconductor laser device, as shown in figure 10, the active regions 4a to 4d of the laser array chip 3 are positioned on the regions of the heat sink 2 where the impurity diffused regions 11 are absent.

In figure 10, when a silicon substrate 150 microns thick is used as the heat sink substrate 25 and the impurity diffused regions 11 about 80 microns deep are formed using the diffusion mask 9 having apertures about 10 microns wide according to the above-described method, the distance between the active regions 4a and 4b around the impurity diffused region 11 is sufficiently longer than the distance from the active region 4a to the surface of the metal block 1.

While in the above-described fifth embodiment the heat sink substrate comprises insulating silicon, it may comprise other insulating materials, such as SiC or AlN.

In place of the impurity diffused regions 11, oxide regions may be formed by thermally oxidizing portions of the heat sink substrate. For example, when portions of the heat sink substrate comprising insulating silicon are thermally oxidized to form relatively low thermal conductivity regions comprising SiO₂, since the thermal conductivity of SiO₂ is only 0.19 W/cm°C while the thermal conductivity of silicon is 1.5 W/cm°C, the same effects as described above are attained.

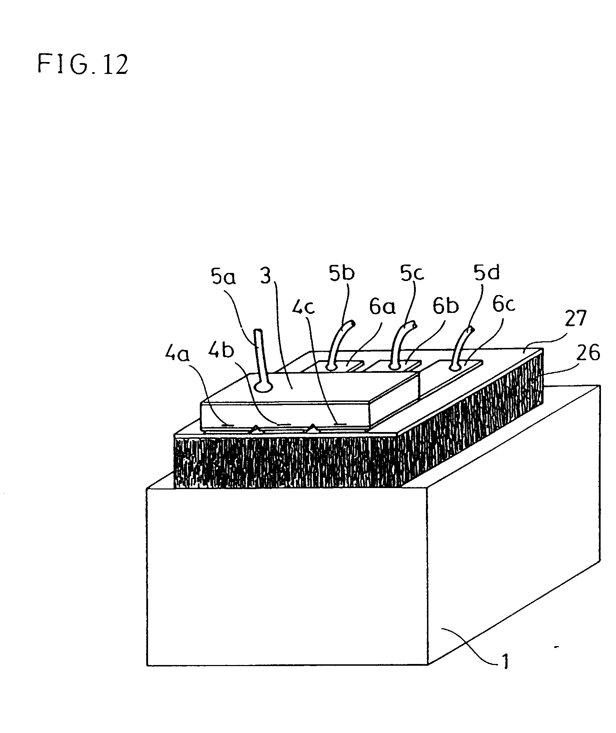

Figure 12 is a perspective view illustrating a semiconductor laser device in accordance with a sixth embodiment of the present invention. In figure 12, the same reference numerals as shown in figure 1 designate the same or corresponding parts. Reference numeral 26 designates a heat sink having an anisotropy of thermal conductivity and numeral 27 designates an SiO₂ film deposited on the heat sink 26.

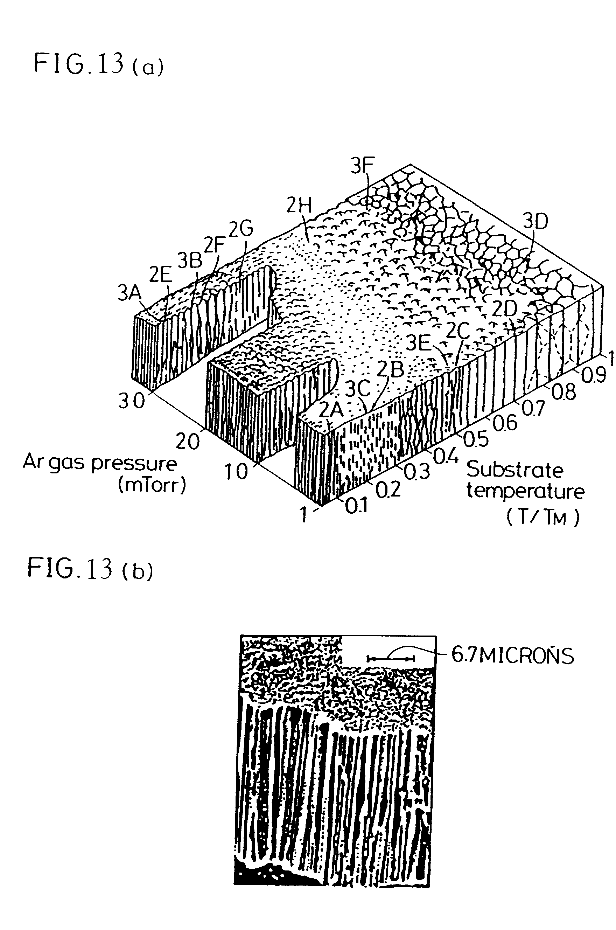

Figure 13(a) is a schematic diagram illustrating different internal structures of a copper film formed by sputtering at various Ar gas pressures and various growth temperatures, and figure 13(b) is a cross section of a copper film formed under the condition at the point 3B of figure 13(a), which are disclosed in Journal of Science Technology, Vol.ll, No.4, pp 666-670.

When the Ar gas pressure (mTorr) and the growth temperature (T/TM where T is the growth temperature and TM is the melting point) are varied during forming a copper film by sputtering, the internal structure of the copper film varies as shown in figure 13(a). Under the condition of the point 3B, i.e., at the Ar gas pressure of 30 mTorr (=3.9 Pa) and the growth temperature T/TM of 0.2 (since the melting point of copper is 1356[K], the temperature T is 271.2[K]), a porous polycrystalline film in which a plurality of voids are present between long and narrow grains is formed.

The thermal conductivity of the porous polycrystalline film is high in the longitudinal direction of the grain, but it is low in the direction perpendicular to the length of the grain because the voids impede the heat transmission. That is, the polycrystalline film has an anisotropy in the thermal conductivity.

In the sixth embodiment of the present invention shown in figure 12, such a porous polycrystalline film having an anisotropy in the heat conductivity is employed as the heat sink 26. In production, the polycrystalline copper film grown under the above-described conditions is formed into the heat sink 26 about 100 microns thick having a surface perpendicular to the length of the grain, and the SiO₂ film 27 is deposited on the surface of the heat sink 26 and, thereafter, the electrode patterns 6a to 6c are formed on the SiO₂ film 27. Since the growth rate under the above-described conditions is about 0.2 micron/min, the polycrystalline film about 100 microns thick is formed in about eight hours. Although each single grain of the polycrystalline film is not always as long as 100 microns, sufficient anisotropy in the heat conductivity is achieved even if the film includes broken grains.

In this embodiment, heat generated in each active region is transmitted to the metal block 1 through the grains. Since the voids impede the heat transmission in the horizontal direction, thermal crosstalks between the active regions through the heat sink are reduced.

While in the sixth embodiment the polycrystalline film comprises copper, it may comprise other metals or insulating materials.

In figure 12, the SiO₂ film 27 disposed on the heat sink 26 is for preventing short circuit between adjacent active regions of the laser array when the heat sink 26 comprises a conductive material like copper. When the heat sink 26 comprises an insulating material, the SiO₂ film 27 is dispensed with.

While in the above-described embodiments junction-down mounting is employed when the semiconductor laser chip is mounted on the heat sink, junction-up mounting may be employed. In this case, although the heat-radiating efficiency is lower than that of the laser device fabricated by the junction-down mounting, reduction in crosstalks is achieved.

While in the above-described embodiments the semiconductor laser array chip including a plurality of stripe-shaped active regions, in which each active region is independently driven, is mounted on the heat sink, a plurality of semiconductor laser chips each having a stripe-shaped active region may be mounted on the heat sink. Also in this case, the same effects as described above are achieved.

While in the above-illustrated embodiments the semiconductor laser array includes three or four active regions, the number of the active regions may be two, five or more.

## Claims

1. A semiconductor laser device comprising:
a semiconductor laser array chip (3) including a plurality of parallel stripe-shaped active regions (4a,4b,4c,4d) extending in a first direction, each region being driven independently; and
a heat sink (2) made of an electrically insulating material on which said semiconductor laser array chip (3) is disposed;
characterised in that
said heat sink (2) includes a plurality of parallel stripe V-grooves (8) haveing a prescribed depth (L5) from the surface of said heat sink (2) and which are periodically disposed in a second direction perpendicular to said first direction of said active regions (4a,4b,4c,4d);
said semiconductor laser array chip (3) is disposed on said heat sink (2) so that each stripe groove (8) is present beneath a region between adjacent active regions (4a, 4b, 4c); and
said depth (L5) is determined so that a distance (L2) from one of said active regions (4a, 4b, 4c) of said semiconductor laser chip (3) to the adjacent active region (4a, 4b, 4c) along the surface of the stripe V-groove (8) between them, is longer than a distance (L1) from the surface of said heat sink (2) which carries the semiconductor laser array chip (3) to the surface opposite to the chip carrying surface.

2. A semiconductor laser device according to claim 1, wherein the V-grooves are filled with air.

3. A semiconductor laser device comprising:
a semiconductor laser array chip (3) including a plurality of parallel stripe-shaped active regions (4a, 4b, 4c, 4d) extending in a first direction, each region being driven independently; and
a heat sink (2) made of electrically insulating material on which said semiconductor laser array chip (3) is disposed;
characterised in that
said heat sink (2) includes a plurality of impurity diffused parallel stripe-shaped low thermal conductivity regions (11), the thermal conductivity being lower than that of the surrounding heat sink (2), which low thermal conductivity regions (11) have a prescribed depth from the surface of said heat sink (2) and which are periodically disposed in a second direction perpendicular to said first direction of said active regions (4a,4b,4c,4d);
said semiconductor laser array chip (3) is disposed on said heat sink (2) so that each low thermal conductivity region (11) is present beneath a region between adjacent active regions (4a, 4b, 4c, 4d); and
said depth is determined so that a distance from one of said active regions (4a, 4b, 4c, 4d) of said semiconductor laser chip (3) to the adjacent active region (4a, 4b, 4c, 4d) along the diffusion front of the low thermal conductivity region (11) between them is longer than a distance from the surface of said heat sink (2) which carries the semiconductor laser array chip (3) to the surface opposite to the chip carrying surface.

4. A semiconductor laser device comprising:
a semiconductor laser array chip (3) including a plurality of parallel stripe-shaped active regions extending in a first direction, each region being driven independently; and
a heat sink (2) made of electrically insulating material on which said semiconductor laser array chip (3) is disposed;
characterised in that
said heat sink (2) includes a plurality of parallel oxide regions which are formed by thermally oxidised portions of the heat sink (2) and and which are periodically disposed in a second direction perpendicular to said first direction of said active regions (4a,4b, 4c), which oxide regions form low thermal conductivity zones which have a thermal conductivity lower than that of the surrounding heat sink material and which low thermal conductivity regions havea prescribed depth from the surface of said heat sink (2); and
said semiconductor laser array chip (3) is disposed on said heat sink (2) so that each low thermal conductivity region is present beneath a region between adjacent active regions; and
said depth is determined so that a distance from one of said active regions of said semiconductor laser chip (3) to the adjacent active region along the surface of the intervening low thermal conductivity region within the heat sink material, is longer than a distance from the surface of said heat sink (2) which carries the semiconductor laser array chip(3) to the surface opposite to the chip carrying surface.

5. A semiconductor laser device comprising:
a semiconductor laser array chip (3) including a plurality of parallel stripe-shaped active regions (4a, 4b, 4c), each region being driven independently; and
a heat sink (26) on which said semiconductor laser array chip (3) is disposed;
characterised in that
said heat sink (26) comprises a polycrystalline layer including columnar or fiber grains which has a thermal anisotropy with the thermal conductivity in the longitudinal direction of the columnar or fiber grains being higher than in a direction perpendicular to that direction; and
said semiconductor laser array chip (3) is disposed on a surface of said heat sink (26), which surface is perpendicular to the longitudinal direction of said columnar or fiber grains.

6. The semiconductor laser device of one of claims 1 to 3 wherein a plurality of independent semiconductor laser chips, each chip including a stripe-shaped active region, are employed as said semiconductor laser array chip (3).

## Patentansprüche

1. Halbleiterlaservorrichtung mit:
einem Halbleiterlaserfeldchip (3) mit einer Mehrzahl von parallelen streifenförmigen aktiven Bereichen (4a, 4b, 4c, 4d), die sich in einer ersten Richtung erstrecken, wobei jeder Bereich unabhängig getrieben wird; und
einem Wärmeableiter (2), der aus einem elektrisch isolierenden Material gemacht ist, auf dem der Halbleiterlaserfeldchip (3) vorgesehen ist;
dadurch gekennzeichnet,
daß der Wärmeableiter (2) eine Mehrzahl von parallelen V-förmigen Streifenrillen (8) enthält mit einer vorgeschriebenen Tiefe (L5) von der Oberfläche des Wärmeableiters (2), und die periodisch in einer zweiten Richtung senkrecht zu der ersten Richtung der aktiven Bereiche (4a, 4b, 4c, 4d) vorgesehen sind; daß der Halbleiterlaserfeldchip (3) auf dem Wärmeableiter (2) so vorgesehen ist, daß jede Streifenrille (8) unterhalb eines Bereiches zwischen benachbarter aktiver Bereiche (4a, 4b, 4c) vorhanden ist; und
daß die Tiefe (L5) so bestimmt ist, daß ein Abstand (L2) von einem der aktiven Bereiche (4a, 5b, 4c) des Halbleiterlaserchips (3) zu dem benachbarten aktiven Bereich (4a, 4b, 4c) entlang der Oberfläche der V-förmigen Streifenrille (8) zwischen ihnen länger als ein Abstand (L1) von der Oberfläche des Wärmeableiters (2), die den Halbleiterlaserfeldchip (3) trägt, zu der Oberfläche gegenüber von der den Chip tragenden Oberfläche ist.

2. Halbleiterlaservorrichtung nach Anspruch 1, bei der die V-förmigen Rillen mit Luft gefüllt sind.

3. Halbleiterlaservorrichtung mit:
einem Halbleiterfeldchip (3) mit einer Mehrzahl von parallelen streifenförmigen aktiven Bereichen (4a, 4b, 4c, 4d), die sich in einer ersten Richtung erstrecken, wobei jeder Bereich unabhängig getrieben wird; und
einem Wärmeableiter (2), der aus einem elektrisch isolierenden Material gemacht ist, auf dem der Halbleiterlaserfeldchip (3) vorgesehen ist;
dadurch gekennzeichnet,
daß der Wärmeableiter (2) eine Mehrzahl von diffundierten parallelen streifenförmigen Störstellenbereichen (11) niedriger thermischer Leitfähigkeit aufweist, wobei die thermische Leitfähigkeit niedriger als die des umgebenden Wärmeableiters (2) ist, die Bereiche (11) niedriger thermischer Leitfähigkeit eine vorgeschriebene Tiefe von der Oberfläche des Wärmeableiters (2) aufweisen, und die periodisch in einer zweiten Richtung senkrecht zu der ersten Richtung der aktiven Bereiche (4a, 4b, 4c, 4d) vorgesehen sind;
daß der Halbleiterlaserfeldchip (3) auf dem Wärmeableiter (2) so vorgesehen ist, daß jeder Bereich (11) niedriger thermischer Leitfähigkeit unter einem Bereich zwischen benachbarten aktiven Bereichen (4a, 4b, 4c, 4d) vorhanden ist; und
daß die Tiefe so bestimmt ist, daß ein Abstand von einem der aktiven Bereiche (4a, 4b, 4c, 4d) des Halbleiterlaserchips (3) zu dem benachbarten aktiven Bereich (4a, 4b, 4c, 4d) entlang der Diffusionsfront des Bereiches (11) niedriger thermischer Leitfähigkeit zwischen ihnen länger als ein Abstand von der Oberfläche des Wärmeableiters (2), die den Halbleiterlaserfeldchip (3) trägt, zu der Oberfläche gegenüber von der den Chip tragenden Oberfläche ist.

4. Halbleiterlaservorrichtung mit:
einem Halbleiterlaserfeldchip (3) mit einer Mehrzahl von parallelen streifenförmigen aktiven Bereichen, die sich in einer ersten Richtung erstrecken, wobei jeder Bereich unabhängig getrieben ist; und
einem Wärmeableiter (2), der aus einem elektrisch isolierenden Material gemacht ist, auf dem der Halbleiterlaserfeldchip (3) vorgesehen ist;
dadurch gekennzeichnet,
daß der Wärmeableiter (2) eine Mehrzahl von parallelen Oxidbereichen aufweist, die durch thermisches Oxidieren von Abschnitten in dem Wärmeableiter (2) gebildet sind und die periodisch in eine zweite Richtung senkrecht zu der ersten Richtung der aktiven Bereiche (4a, 4b, 4c) vorgesehen sind, wobei die Oxidbereiche Zonen niedriger thermischer Leitfähigkeit bilden, die eine thermische Leitfähigkeit niedriger als die des umgebenden Wärmeableitermateriales aufweisen und wobei die Bereiche niedriger thermischer Leitfähigkeit eine vorgeschriebene Tiefe von der Oberfläche des Wärmeableiters (2) aufweisen; und
daß der Halbleiterlaserfeldchip (3) auf dem Wärmeableiter (2) so vorgesehen ist, daß jeder Bereich niedriger thermischer Leitfähigkeit unterhalb eines Bereiches zwischen benachbarten aktiven Bereichen vorhanden ist; und
daß die Tiefe so bestimmt ist, daß ein Abstand von einem der aktiven Bereiche des Halbleiterlaserchips (3) zu dem benachbarten aktiven Bereich entlang der Oberfläche des zwischenliegenden Bereiches niedriger thermischer Leitfähigkeit innerhalb des Wärmeableitermateriales länger als ein Abstand von der Oberfläche des Wärmeableiters (2), die den Halbleiterlaserfeldchip (3) trägt, zu der Oberfläche gegenüber von der den Chip tragenden Oberfläche ist.

5. Halbleiterlaservorrichtung mit:
einem Halbleiterlaserfeldchip (3) mit einer Mehrzahl von parallelen streifenförmigen aktiven Bereichen (4a, 4b, 4c), wobei jeder Bereich unabhängig getrieben ist; und
einem Wärmeableiter (26), auf dem der Halbleiterlaserfeldchip (3) vorgesehen ist;
dadurch gekennzeichnet,
daß der Wärmeableiter (26) eine polykristalline Schicht mit säulenartigen oder faserartigen Körnern aufweist, die eine thermische Anisotropie aufweist, wobei die thermische Leitfähigkeit in der Längsrichtung der säulenartigen oder faserartigen Körner höher als in einer Richtung senkrecht zu dieser Richtung ist; und
daß der Halbleiterlaserfeldchip (3) auf einer Oberfläche des Wärmeableiters (26) vorgesehen ist, wobei die Oberfläche senkrecht zu der Längsrichtung der säulenartigen oder faserartigen Körner liegt.

6. Halbleiterlaservorrichtung nach einem der Ansprüche 1 bis 3, bei der eine Mehrzahl von unabhängigen Halbleiterlaserchips, wobei jeder Chip einen streifenförmigen aktiven Bereich aufweist, als der Halbleiterlaserfeldchip (3) verwendet wird.

## Revendications

1. Un dispositif laser semi-conducteur comprenant:
- une pastille à réseau laser semi-conducteur (3) comprenant une pluralité de zones actives parallèles en forme de bande (4a, 4b, 4c, 4d) s'étendant selon une première direction, chaque zone étant pilotée de façon indépendante; et
- un puits de chaleur (2) réalisé en un matériau électriquement isolant, et sur lequel est disposée ladite pastille à réseau laser semi-conducteur (3);
caractérisé en ce que ledit puits de chaleur (2) comprend une pluralité de rainures parallèles (8), en forme de V et disposées en bandes, présentant une profondeur déterminée (L5) mesurée à partir de la surface du puits de chaleur (2), et qui sont disposées périodiquement selon une deuxième direction, perpendiculaire à ladite première direction desdites zones actives (4a, 4b, 4c, 4d);
en ce que ladite pastille à réseau laser semi-conducteur (3) est disposée sur ledit puits de chaleur (2), de sorte que chaque rainure en forme de bande (8) soit présente en-dessous d'une zone entre des zones actives adjacentes (4a, 4b, 4c); et
en ce que ladite profondeur (L5) est déterminée de sorte qu'une distance (L2) entre l'une desdites zones actives (4a, 4b, 4c) de ladite pastille laser semi-conducteur et la zone active adjacente (a, 4b, 4c) mesurée le long de la surface de la rainure en forme de V, disposée en bande (8) les séparant, est supérieure à une distance (L1) entre la surface dudit puits de chaleur (2) portant la pastille à réseau laser semi-conducteur (3) et la surface opposée à la surface portant la pastille.

2. Un dispositif laser semi-conducteur selon la revendication 1, dans lequel les rainures en forme de V sont remplies d'air.

3. Un dispositif laser semi-conducteur comprenant:
- une pastille à réseau laser semi-conducteur (3) comprenant une pluralité de zones actives parallèles en forme de bande (4a, 4b, 4c, 4d) s'étendant selon une première direction, chaque zone étant pilotée de façon indépendante; et
- un puits de chaleur (2) réalisé en un matériau électriquement isolant, et sur lequel est disposée ladite pastille à réseau laser semi-conducteur (3);
caractérisé en ce que ledit puits de chaleur (2) présente une pluralité de zones en forme de bandes parallèles (11), traitées par diffusion d'impuretés et à faible conductivité thermique, présentant une conductivité thermique inférieure à celle du puits de chaleur environnant (2), lesdites zones à faible conductivité thermique (11) présentant une profondeur déterminée, mesurée à partir de la surface dudit puits de chaleur (2), en étant disposée périodiquement selon une deuxième direction perpendiculaire à ladite première direction desdites zones actives (4a, 4b, 4c, 4d);
en ce que ladite pastille à réseau laser semi-conducteur (3) est disposée sur ledit puits de chaleur (2), de sorte que chaque zone à faible conductivité thermique (11) soit présente en-dessous d'une zone entre des zones actives adjacentes (4a, 4b, 4c, 4d); et
en ce que ladite profondeur est déterminée de sorte qu'une distance entre l'une desdites zones actives (4a, 4b, 4c, 4d) de ladite pastille laser semi-conducteur (3) et la zone active adjacente (4a, 4b, 4c, 4d), mesurée le long de la frontière de diffusion de la zone à faible conductivité thermique (11) les séparant, soit supérieure à une distance entre la surface dudit puits de chaleur (2) portant la pastille à réseau laser semi-conducteur (3) et la surface opposée à la surface portant la pastille.

4. Un dispositif laser semi-conducteur comprenant:
- une pastille à réseau laser semi-conducteur (3) comprenant une pluralité de zones actives parallèles en forme de bande s'étendant selon une première direction chaque zone étant pilotée de façon indépendante; et
- un puits de chaleur (2) réalisé en un matériau électriquement isolant, et sur lequel est disposée ladite pastille à réseau laser semi-conducteur (3);
caractérisé en ce que ledit puits de chaleur (2) comprend une pluralité de zones parallèles en oxyde, qui sont formées de parties oxydées ternissement du puits de chaleur (2) et qui sont disposées périodiquement selon une deuxième direction perpendiculaire à ladite première direction desdites zones actives (4a, 4b, 4c), lesdites zones d'oxyde constituant des zones à faible conductivité thermique présentant une conductivité thermique inférieure à celle du matériau environnant du puits de chaleur, lesdites zones à faible conductivité thermique présentant une profondeur déterminée, mesurée à partir de la surface dudit puits de chaleur (2); et
en ce que ladite pastille à réseau laser semi-conducteur (3) est disposée sur ledit puits de chaleur (2), de sorte que chaque zone à conductivité thermique faible soit présente en-dessous d'une zone entre des zones actives adjacentes; et
en ce que ladite profondeur est déterminée de sorte qu'une distance entre l'une desdites zones actives de ladite pastille laser semi-conducteur (3) et la zone active adjacente, mesurée le long de la surface en cause de la zone intermédiaire à faible conductivité thermique au sein du matériau dudit puits de chaleur, soit supérieure à une distance entre la surface dudit puits de chaleur (2) portant la pastille à réseau laser semi-conducteur (3) et la surface opposée à la surface portant la pastille.

5. Un dispositif laser semi-conducteur comprenant:
- une pastille à réseau laser semi-conducteur (3) comprenant une pluralité de zones actives parallèles, en forme de bande (4a, 4b, 4c), chaque zone étant pilotée de façon indépendante; et
- un puits de chaleur (26), sur lequel est disposée ladite pastille à réseau laser semi-conducteur (3);
caractérisé en ce que ledit puits de chaleur (26) comprend une couche polycristalline comprenant des grains en colonnes ou en fibres présentant une anisotropie thermique, la conductivité thermique selon la direction longitudinale des grains en colonnes ou en fibres étant supérieure à la conductivité thermique selon une direction perpendiculaire à cette direction; et
en ce que ladite pastille à réseau laser semi-conducteur (3) est disposée sur une surface dudit puits de chaleur (26), cette surface étant perpendiculaire à la direction longitudinale desdits grains en colonnes ou en fibres.

6. Le dispositif laser semi-conducteur selon l'une des revendications 1 à 3, dans lequel une pluralité de pastilles laser semi-conducteur indépendantes, chaque pastille comprenant une zone active en forme de bande, sont utilisées pour constituer ladite pastille à réseau laser semi-conducteur (3).
